# EUROPEAN PATENT APPLICATION

(11) **EP 1 387 451 A1**
(43) Date of publication of application: **04.02.2004**
(21) Application number: 02255368.9
(22) Date of filing: 31.07.2002
(51) Int. Cl.: H01S 5/06

(54) **Optical communication devices and their operation**

(71) Applicant: CORNING INCORPORATED, Corning, N.Y. 14831 (US)
(72) Inventor: Moodie, David Graham, Hasketon, Suffolk IP13 6LA (GB)
(74) Representative: Poole, Michael John

(57) **Abstract**

An optical communication device (especially an electroabsorption modulator) and a method of operating it in which the operation of the device requires light to be absorbed progressively as it is passed through the active absorbing zone of the device and in which the light signal is amplified within the length of the active absorbing zone.

Two distinct structures for implementing the invention are proposed:
In the first, the device is subdivided into segments which are interconnected so as to perform substantially the same function and at least one semiconductor optical amplifier stage is interposed between its segments, and optionally before the first and/or after the last segment;
In the second, an optical waveguide is formed in which the mode field is, for at least a substantial length, partly contained in an active absorbing layer of the device and partly in a semiconductor optical amplifier layer, so that modulation due to electroabsorption (or other electro-optical effect or optically actuated effect or photodetection) is accompanied by simultaneous amplification.

Ideally the degree of amplification will be such that the optical amplitude is substantially constant (or substantially the same at the corresponding place in each segment).

## Description

This invention relates to the field of optical communications, and more particularly to optical devices whose operation requires the progressive absorption of light as it propagates along the length of an active absorbing zone of the device and to methods of operating them. It relates especially (but not exclusively) to electroabsorption modulators and to photodetectors, such as *pin* photodiodes. Electroabsorption modulators (EAMs) are used for converting electrical digital signals to optical digital signals, and sometimes for converting electrical analogue signals to an optical equivalent. They are much smaller than the alternative lithium niobate Mach-Zehnder interferometer modulators, are potentially less expensive, and require less electrical power. On the other hand they are somewhat limited in the optical output power they can provide, which is a significant weakness in the context that the insertion loss of the device is liable to be around 11dB (including 3dB coupling losses at each end of the device and a further loss of at least 3dB because, when transmitting data, the device will be in the transmitting state for no more than half the time). Specifically, no 40Gbit/s EAM reported in literature known to the applicant has achieved an optical output higher than about 1dBm, whereas at least 3dBm would be desirable.

It is possible to integrate a semiconductor optical amplifier (SOA) with an EAM: but if it is located upstream (to increase the input power level) it is merely equivalent to using a more powerful source laser, and there is a risk that photo-generated carriers will accumulate in the active absorbing region of the modulator, which limits the gain that can be achieved without reducing the modulator's effectiveness, depending on the incoming light level; and if it is located downstream, to amplify the output from the modulator, it is liable introduce distortion (because its characteristic is not perfectly linear) and noise.

Another undesirable characteristic of the EAM (and any light-absorbing electro-optical device) is that the light-absorbing material is used inefficiently because, in the nature of absorption, the intensity of the light falls off exponentially along the length of the device, with the result that saturation will occur at the input end of the device while the material at the output end receives much less light than its optimum, and (at least for an EAM) the optimum electrical bias value can be different at each point along the length of the device. It would be possible to segment the device so that different bias voltages can be applied to different segments, but the benefits of this are limited, and may not justify the complexity of the structure.

Similar problems may arise in designing other electro-optical devices; for example in *pin* photodiodes the active material is used inefficiently at the downstream end of the active zone and the electrical output is unequally distributed along the length of the device.

In accordance with one aspect of the invention, a method of operating an optical communication device whose operation requires the progressive absorption of light as it propagates along the length of an active absorbing zone of the device comprising passing a light signal through the active absorbing zone of the device is *characterised* by amplifying the light signal within the length of the said active absorbing zone. In different forms of the invention, which will be explained shortly, the active zone may be discontinuous or continuous; in the former case, the "length" of the active absorbing zone is to be understood as the total length of the light path from its entry into the active absorbing zone to its exit from it.

In accordance with another aspect of the invention, an optical communication device whose operation requires the progressive absorption of light as it propagates along the length of an active absorbing zone of the device integrated with a semiconductor optical amplifier is *characterised* in that the amplifier is located within the length of the active absorbing zone of the said device.

When the invention is applied to an electroabsorption modulator, an electrical signal may be applied to generate an electrical field in its active absorbing zone and so alter its optical absorption characteristics. If the electrical signal is pulsed, a digital optical output signal will result; if it is an electrical analogue signal, an optical analogue signal can be obtained. The optical absorption characteristics can also be altered by an optical input signal, at least under some conditions of electrical bias.

Two distinct structures for implementing the invention are proposed:

In the first structure, the modulator or other electro-optical device is subdivided into segments which are interconnected so as to perform substantially the same function and at least one semiconductor optical amplifier stage is interposed between its segments, and optionally before the first and/or after the last segment. A structure in which one or more optical amplifier stage is integrated with two separate EAMs is known, for example, from a paper by Devaux et al in IEEE Photonics Technology Letters vol 8 no 2 (February 1996) pages 218-220: in this known structure, each of the two independently connected EAMs (or other devices) will be designed to absorb, under some conditions, as nearly as practicable all the light incident upon them (typically more than 90%)in order that each can carry out its separate modulation function, that is data modulation and pulse generation; in contrast, in the present invention each of the two or more interconnected segments (except optionally the last) will ordinarily be only long enough to absorb a fraction of the incident light appropriate to the number of segments used (rarely as much as 80%).

In the second structure, an optical waveguide is formed in which the mode field is, for at least a substantial length, partly contained in an active absorbing layer of the device and partly in a semiconductor optical amplifier gain layer.

In either case, the optical amplitude can be kept relatively constant and relatively high along the length of the device, instead of reducing exponentially from the entry to the exit of the device, so that (in an EAM) different bias voltages are not needed and noise and distortion introduced by each part of the SOA is removed to a significant extent by a part of the modulator downstream of it.

In either case, the EAM or other active electro-optical device is preferably a buried-heterostructure device; but the alternative deeply-etched ridge device may also be used and in particular a buried-heterostructure EAM may be formed on top of a ridge SOA.

In the first structural form of the invention, some advantage is believed obtainable even with two electro-optically active absorbing segments and a single SOA segment located between them, but we prefer to have at least two and more especially at least three segments of each kind. A travelling wave technique may be used to facilitate synchronisation of the effect of the successive modulator segments upon the light as it propagates along the device.

In the second structural form of the invention as applied to an EAM, we prefer to locate an SOA gain layer nearer to a substrate than the absorber layer of the EAM, but the inverse structure with the absorber layer nearer the substrate can also be used. In all cases, a buffer layer is preferably first applied to the substrate, in accordance with usual practice, to protect from defects that are likely to be present in the substrate surface. Preferably the shape and dimensions of the combined layers are such that (as nearly as possible) only a single guided mode is supported. Preferably the absorber layer is appropriately tapered to obtain an enlarged mode field diameter at one or preferably each end of the device, in order to improve compatibility with fibre or dielectric waveguides and so reduce insertion losses.

Optical communication devices in accordance with the invention may, if desired, be integrated with other devices on the same chip. In particular, an EAM in accordance with the invention may be integrated with a second EAM to perform a different modulation function. The second EAM may optionally be a device in accordance with the invention. In some cases where both EAMs are devices in accordance with the invention and both of the first structure, only the interconnections may determine the EAM to which individual segments belong.

Apart from its use in modulating a continuous-wave optical signal, the combined EAM/SOA of the invention can be used for retiming and/or reshaping an input pulse signal, or in light-actuated optical switching, mode-locked lasers, or distributed EAM based pulse sources. In the light-actuated optical switching application, it may not be necessary to apply any radio-frequency signals to the EAM section(s).

The invention will be further described, by way of example, with reference to the accompanying drawings in which:
Figure 1 is a diagrammatic cross-section of an integrated EAM-SOA of the first kind in accordance with the invention;
each of Figures 2-4 is a diagrammatic transverse cross-section of a different integrated EAM-SOA of the second kind in accordance with the invention; and
Figure 5 is an isometric view of a portion of a device of the second kind, which may accord with any one of Figures 2, 3 and 4.

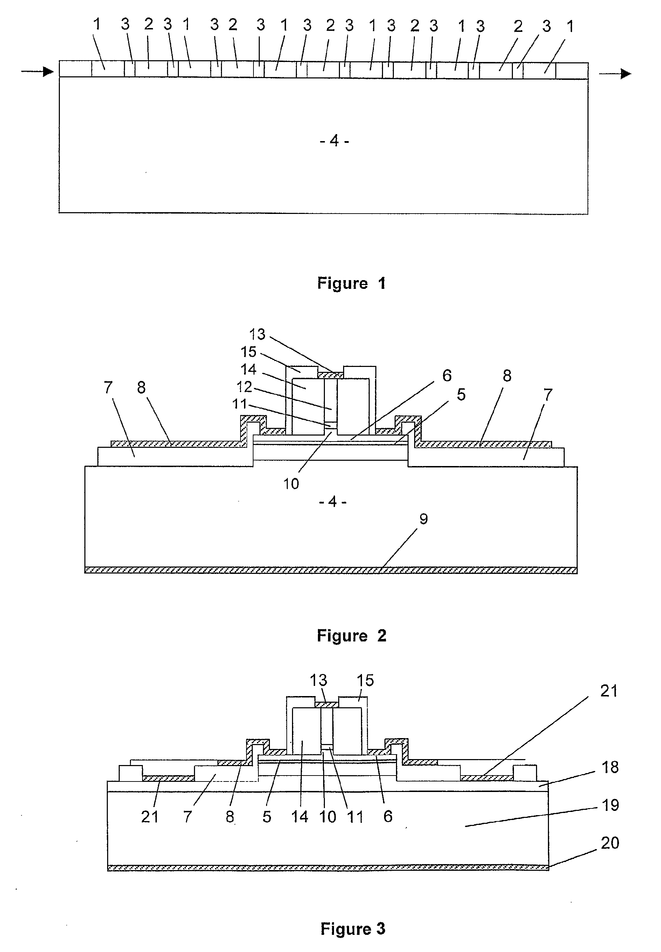

The integrated EAM-SOA of Figure 1 consists simply of an EAM subdivided into a plurality of segments 1 with SOA segments 2 aligned and alternating along the length of the device and separated by short passive waveguide segments 3, all supported on a common substrate 4. Each of the EAM and SOA segments individually may be of any conventional structure, provided that their mode fields need to be reasonably consistent in shape and dimensions, and each EAM segment is designed to absorb only a fraction of the light incident on it (for example, about 80% if there were only two EAM segments, 66% if there were three, or 42% if there were six). The EAM segments are appropriately interconnected so as to apply in substance the same input signal and thus perform the same modulating function; they may be AC coupled, to allow different bias levels, should it be found desirable (if the EAM segments are otherwise alike and the SOA segments are effective to restore the initial optical amplitude, it should not be needed).

The form of the invention shown in Figure 2 comprises a buried-heterostructure (BH) EAM integrated with and on top of a ridge SOA; a substrate 4 of n-type indium phosphide supports an SOA gain layer 5 of conventional composition, which in turn is covered by a thin layer 6 of p-type indium phosphide. Lateral dielectric ribbons 7, 7 allow contact to be made with layer 6 by metal electrodes 8, 8 and a counterelectrode 9 on the underside of the substrate completes a ridge SOA structure.

The p-type layer 6 has an upstanding ridge 10 on top of which is a multiple-quantum-well EAM active absorber layer 11, to which an upper electrical connection is made by an n-type indium phosphide region 12 and metal electrode 13, while the sides of the EAM portion are enclosed with blocks of semi-insulating iron-doped indium phosphide 14, 14 and dielectric coatings 15, 15.

The active waveguide in this device is formed in and around the EAM absorber layer and the SOA gain layer directly below it, so that the mode field comprises comparable cross-sectional areas of EAM absorber and SOA gain material. Thus the EAM and SOA operate, in a sense independently of each other, so that the SOA part continuously amplifies the optical signal at the same time as it is modulated by the EAM part and would otherwise be declining exponentially in amplitude. Ideally, the peak optical amplitude remains the same throughout the length of the device.

The device of Figure 3 is essentially the same, except that the n-type indium phosphide forming the base 18 for the SOA is a thin layer carried on a separate substrate 19 of semi-insulating iron-doped indium phosphide; optionally there may be a metal coating 20 on the reverse of the substrate to facilitate bonding to a package or other support. Counter-electrodes for the SOA are now provided laterally at 21, 21.

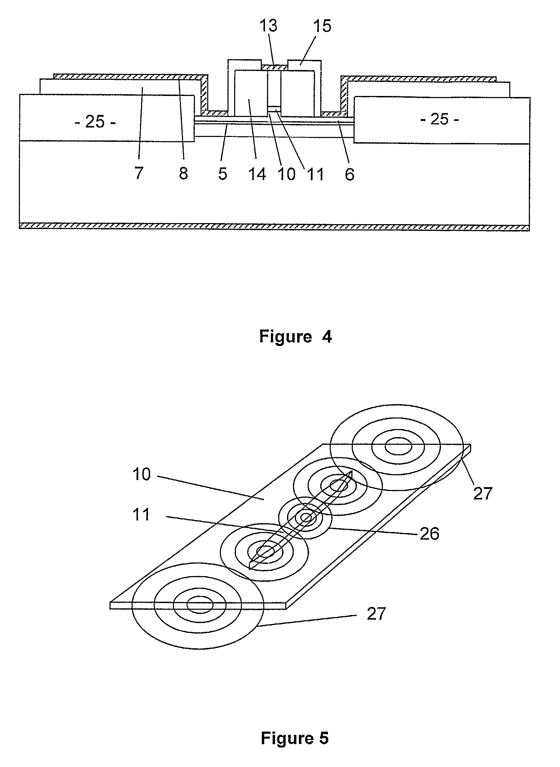

The device of Figure 4 is also very similar to that of Figure 2: it differs in having lateral bands 25, 25 of semi-insulating iron-doped indium phosphide, making it a fully BH structure.

Figure 5 illustrates diagrammatically how the EAM absorber layer 11 (in any of the three examples of Figures 2-4) can be tapered so as to obtain a relatively small mode field 26 in the central active region of the device (to maximise device efficiency) and relatively larger mode fields 27 at the ends of the device (to maximise coupling efficiency and minimise insertion loss).

Any of the three devices just described can be reversed in polarity by interchanging n-type and p-type indium phosphide. Similar structures with the SOA gain layer further from the substrate than the EAM layer could also be used if it became important to trade modulation speed against SOA gain and efficiency.

*Any discussion of the background to the invention herein is included to explain the context of the invention. Where any document or information is referred to as "known", it is admitted only that it was known to at least one member of the public somewhere prior to the date of this application. Unless the content of the reference otherwise clearly indicates, no admission is made that such knowledge was available to the public or to experts in the art to which the invention relates in any particular country (whether a member-state of the PCT or not), nor that it was known or disclosed before the invention was made or prior to any claimed date. Further, no admission is made that any document or information forms part of the common general knowledge of* *the art either on a world-wide basis or in any country and it is not believed that any of it does so.*

## Claims

1. A method of operating an optical communication device whose operation requires the progressive absorption of light as it propagates along the length of an active absorbing zone of the device comprising passing a light signal through the active absorbing zone of the device ***characterised* by** amplifying the light signal within the length of the said active absorbing zone.

2. A method of operating an electroabsorption modulator in accordance with claim 1 in which an electrical signal is applied to generate an electric field in its active absorbing zone and so alter its optical absorption characteristics.

3. A method as claimed in claim 1 or claim 2 comprising using a pulsed electrical signal to generate a digital optical output signal.

4. A method as claimed in claim 1 or claim 2 comprising using an electrical analogue signal to generate an optical analogue signal.

5. A method of operating an electroabsorption modulator in accordance with claim 1 or claim 2 in which an optical signal is applied to alter its optical absorption characteristics.

6. A method as claimed in any one of claims 1-5 comprising using an electroabsorption modulator or other electro-optical device which is subdivided into segments which are interconnected so as to perform substantially the same function and in which at least one semiconductor optical amplifier stage is interposed between its segments and optionally before the first and/or after the last segment.

7. A method as claimed in claim 6 comprising using at least two segments of each kind.

8. A method as claimed in claim 6 comprising using at least three segments of each kind.

9. A method as claimed in any one of claims 6-8 comprising using a travelling wave technique to facilitate synchronisation of the effect of the successive modulator segments upon the light as it propagates along the length of the device.

10. A method as claimed in claim 1 or claim 2 comprising using a device in which an optical waveguide is formed in which the mode field is, for at least a substantial length, partly contained in an active absorbing layer of the device and partly in a semiconductor optical amplifier layer.

11. A method as claimed in claim 10 of operating an EAM comprising using a device with an SOA gain layer nearer a substrate than the absorber layer of the EAM.

12. A method as claimed in claim 10 of operating an EAM comprising using a device with the absorber layer of the EAM nearer a substrate than the gain layer of the SOA.

13. A method as claimed in any one of claims 10-12 comprising using a shape and dimensions for the combined layers such that (as nearly as possible) only a single guided mode is supported.

14. A method as claimed in any one of claims 10-13 comprising using an absorber layer that is appropriately tapered to obtain an enlarged mode field diameter at one or preferably each end of the device.

15. An optical communication device whose operation requires the progressive absorption of light as it propagates along the length of an active absorbing zone of the device integrated with a semiconductor optical amplifier ***characterised* in that** the amplifier is located within the length of the active absorbing zone of the said device.

16. An optical communication device in accordance with claim 15 which is subdivided into segments which are interconnected so as to perform substantially the same function and has at least one semiconductor optical amplifier stage interposed between its segments, and optionally before the first and/or after the last segment.

17. An optical communication device in accordance with claim 16 in which there are at least two segments of each kind.

18. An optical communication device in accordance with claim 16 in which there are at least three segments of each kind.

19. An optical communication device in accordance with any one of claims 16-19, being an integrated electroabsorption modulator and semiconductor optical amplifier.

20. An optical communication device in accordance with claim 15 comprising a waveguide in which the mode field is, for at least a substantial length, partly contained in an active absorbing layer of the device and partly in a semiconductor optical amplifier layer.

21. An optical communication device as claimed in claim 20 in which the shape and dimensions of the combined layers are such that (as nearly as possible) only a single guided mode is supported.

22. An optical communication device in accordance with claim 20 or claim 21 being an integrated electroabsorption modulator and semiconductor optical amplifier and in which a semiconductor optical amplifier gain layer is closer to a substrate than the absorber layer of a electroabsorption modulator.

23. An optical communication device in accordance with claim 20 or claim 21 being an integrated electroabsorption modulator and semiconductor optical amplifier and in which the absorber layer of a electroabsorption modulator is closer to a substrate than a semiconductor optical amplifier gain layer.

24. An optical communication device in accordance with any one of claims 20-23 in which the absorber layer is appropriately tapered to obtain an enlarged mode field diameter at one or preferably each end of the device.
